Europäisches Patentamt

European Patent Office

Office européen des brevets

(11) Numéro de publication: **0 427 258 A1**

# DEMANDE DE BREVET EUROPEEN

(21) Numéro de dépôt: 90121393.4

(22) Date de dépôt: **22.09.87**

(51) Int. Cl.⁵: **G07C 5/08**, H05K 5/02

Cette demande a été déposée le 08 - 11 - 1990 comme demande divisionnaire de la demande mentionnée sous le code INID 60.

(30) Priorité: 30.09.86 FR 8613616

(43) Date de publication de la demande:
**15.05.91 Bulletin 91/20**

(60) Numéro de publication de la demande initiale en application de l'article 76 CBE : **0 263 019**

(84) Etats contractants désignés:
**BE CH DE ES FR GB GR IT LI LU NL SE**

(71) Demandeur: **DASSAULT ELECTRONIQUE**
**55, quai Marcel Dassault**
**F-92214 Saint-Cloud(FR)**

(72) Inventeur: **Clavelloux, Michel**
**19, rue Charles Gounod, Longpont Sur Orge**
**F-91310 Montlhery(FR)**
Inventeur: **Ropert, Maurice**
**1, rue Alfred de Musset**
**F-78370 Plaisir(FR)**

(74) Mandataire: **Plaçais, Jean-Yves et al**
**Cabinet Netter, 40, rue Vignon**
**F-75009 Paris(FR)**

(54) Dispositif enregistreur de vol à mémoire électronique statique.

(57) Un enregistreur de vol (MPV) est contenu à l'intérieur d'une enceinte à deux parois (11, 13) séparées par une substance anti-feu (12). Les organes de mémoire sont faits de circuits hybrides (H1-H8), du type EEPROM. Les paramètres de vol sont enregistrés en alternat dans deux cartes de mémoire (CM1 et CM2), ainsi que dans les circuits hybrides que comprennent celles-ci.

FIG. 3A

EP 0 427 258 A1

# DISPOSITIF ENREGISTREUR DE VOL À MÉMOIRE ÉLECTRONIQUE STATIQUE.

La présente invention concerne les dispositifs enregistreurs de paramètres de vol, ou plus brièvement enregistreurs de vol.

Installés à bord d'aéronefs civils ou militaires, les enregistreurs de vol ont pour but de permettre l'acquisition de données essentielles relatives au vol en cours, et l'enregistrement de données relatives à un ou plusieurs vols, en vue de leur restitution ultérieure éventuelle. Cette restitution peut avoir lieu simplement à propos d'un vol qui s'est déroulé sans encombre. Malheureusement, il arrive aussi qu'elle soit rendue néoessaire par un accident, qui parfois grave.

Cette dernière constatation fait que les enregistreurs doivent satisfaire des conditions de survie extrêmement contraignantes.

Jusq'à présent, l'enregistreur de vol est un enregistreur à bande magnétique. On s'efforce, par une protection physique convenable de cet enregistreur à bande, de lui permettre de satisfaire les conditions de survie.

Ces enregistreurs ont une fiabilité médiocre, due à leurs pièces méchaniques en mouvement, et à la dégradation de la bande en atmosphère humide. Il est donc souhaitable de les remplacer par des équipments de technologie plus performante.

Le problème est d'obtenir un enregistreur de vol qui tienne des conditions de survie extrêmement contraignantes: chocs et/ou écrasement et/ou poinçonnement violents; exposition prolongée à une flamme; immersion prolongée dans l'un quelconque des liquides présents dans l'aéronef, ainsi que dans l'eau de mer; survie dans l'eau de mer à grande profondeur et sous haute pression.

Il est intéressant de prévoir un enregistreur de vol équipé d'une mémoire électronique statique. Mais ceci pose des problèmes nouveaux tant au point de vue de sécurité de conservation des données inscrites en mémoire, ainsi que pour les récupérer, compte-tenu desdites conditions contraignantes.

Différents autres problèmes sont à résoudre, comme on le verra plus loin, dans la description détaillée.

La présente invention vient maintenant proposer un dispositif enregistreur de vol qui est du type comportant une enceinte de protection traversée par des connexions électriques d'alimentation et de signaux, aboutissant à des organes de mémoire logés à l'intérieur de l'enceinte, et comprenant des circuits hybrides de mémoire non volatile à réinscription électrique, en particulier du type EEPROM, qui n'ont pas besoin d'alimentation électrique autonome pour la conservation des données, et sont susceptibles d'accès par l'intermédiaire desdites connexions (FR-A-2551619).

L'invention part du fait que les organes de mémoire comprennent au moins une carte de circuits hybrides de mémoire, et une carte de circuits de commande, propre à constituer interface entre un processeur et les circuits hybrides de mémoire. Selon l'invention, des mesures consécutives d'une même grandeur à enregistrer sont distribuées alternativement à au moins deux ensembles de circuits hybrides de mémoire; de plus, des groupes consécutifs de données à enregistrer dans chaque ensemble sont distribués séquentiellement aux différents circuits hybrides de celui-ci.

Très avantageusement, les différents ensembles de mémoire sont électriquement séparés, et actionnés par des voies séparées.

D'un autre point de vue, tout vol fait l'objet d'un enregistrement alterné de ses paramètres (en particulier par cycles d'enregistrement de paramètres, où certains paramètres peuvent être surconnectés, c'est-à-dire échantillonnés plusieurs fois) dans deux zones différentes de mémoire. Ceci permet de disposer, en cas de panne totale ou partielle d'une des deux zones, de toute la durée du vol à cadence moitié. Naturellement, un tel enregistrement à cadence moitié peut aussi être réalisé sur commande, si on le désire.

Très avantageusement, chaque groupe de paramètres de vol à enregistrer (on appellera ci-après un tel groupe "module de vol") contient normalement un nombre entier de cycles comprenant chacun l'ensemble des paramètres de vol à enregistrer.

Ceci permet une compression de données particulièrement intéressante, qui fait l'objet d'un autre aspect de l'invention.

En effet, chaque module de vol contient alors, en principe au début, un cycle de référence, comprenant un bloc de données enregistrées qui forme un codage complet de l'ensemble des paramètres à enregistrer. Ce cycle de référence est suivi de cycles dits secondaires, comprenant des blocs de données constitués chacun d'un identificateur, capable de prendre au moins trois états différents, tandis que le reste du bloc est : inexistant, si l'identificateur indique que le paramètre de vol n'a pas varié par rapport à sa valeur précédente, à une précision choisie; constitué d'un nombre restreint de bits si l'identificateur indique que le paramètre de vol n'a varié, par rapport à sa valeur précédente, que dans un domaine restreint choisi, définissable par ce nombre restreint de bits; constitué de la totalité des bits du codage dans l'autre cas, c'est-à-dire si la variation du paramètre de vol est plus importante.

De préférence, il est associé à chaque module de vol l'enregistrement initial d'une identification du vol, d'une identification du module de vol, et du temps écoulé depuis le début du vol.

On examinera maintenant un autre aspect nouveau de l'invention.

Chaque bloc de données relatif à un cycle de vol est de préférence suivi de l'indication du nombre de bits que contient ce bloc; chaque groupe de données définissant un module de vol est, de même, suivi de l'indication du nombre de bits que contient ce groupe, puis d'au moins un signal spécial de synchronisation.

Ceci est intéressant car la mémoire peut faire l'objet d'une interruption d'alimentation, soit accidentelle, soit le plus souvent parce que l'enregistrement des paramètres du vol se poursuit jusqu'à la disparition de l'alimentation de bord de l'aéronef, et qu'il est par conséquent difficile de prévoir un marquage spécial pour la fin du vol.

Avec les moyens qui viennent d'être exposés, le recalage dans la mémoire après une interruption d'alimentation s'effectue en parcourant la mémoire à l'envers, pour y chercher d'abord les signaux de synchronisation relatifs au module le plus récent du vol le plus récent, puis pour suivre les modules de vol en remontant le temps.

Bien entendu, la mémoire tourne en boucle, c'est-à-dire que, lorsqu'elle est pleine, des informations récentes vont venir effacer les informations anciennes. Mais, avec le mode de réalisation ici envisagé, ces informations anciennes ne sont pas forcément les plus anciennes, contrairement à ce qui se produisait avec des bandes magnétiques.

De ce fait, les phases préliminaires de recalage dans la mémoire selon l'invention, qui viennent d'être décrites, se poursuivent avantageusement jusqu'à la détermination du vol le plus ancien, dont tous les modules de vol sont représentés en mémoire.

D'autres caractéristiques et avantages de l'invention apparaîtront à l'examen de la description détaillée ci-après, et des dessins annexés, sur lesquels :

- la figure 1 illustre, sous la forme d'une vue schématique en perspective un dispositif de mémoire selon l'invention, associé à un dispositif d'acquisition des paramètres de vol;
- la figure 2 est le schéma électrique de principe des deux dispositifs de la figure 1;
- les figures 3A et 3B sont une vue en coupe verticale et une vue en coupe horizontale, respectivement, du dispositif de mémoire selon l'invention;
- les figures 4A, 4B et 4C illustrent l'interconnexion et la structure des trois cartes que comprend le dispositif de mémoire selon l'invention;
- les figures 5, 5A et 5B sont respectivement une vue en perspective d'un circuit hybride utilisé selon l'invention, et des vues en coupe de deux variantes de ce circuit hybride;
- la figure 6 est un schéma de principe de la carte de commande du dispositif de mémoire selon l'invention;
- la figure 7 est un schéma de cartographie mémoire permettant de mieux comprendre le fonctionnement du dispositif selon l'invention;
- la figure 8 est un autre schéma de cartographie mémoire permettant de mieux comprendre le fonctionnement du dispositif selon l'invention; et
- la figure 9 est un troisième schéma de cartographie mémoire permettant de mieux comprendre le fonctionnement du dispositif selon l'invention.

Les dessins annexés comportent à de nombreux titres des informations de caractère certain. Ils pourront en conséquence non seulement servir à faire mieux comprendre la description détaillée ci-après, mais aussi contribuer à la définition de l'invention, le cas échéant.

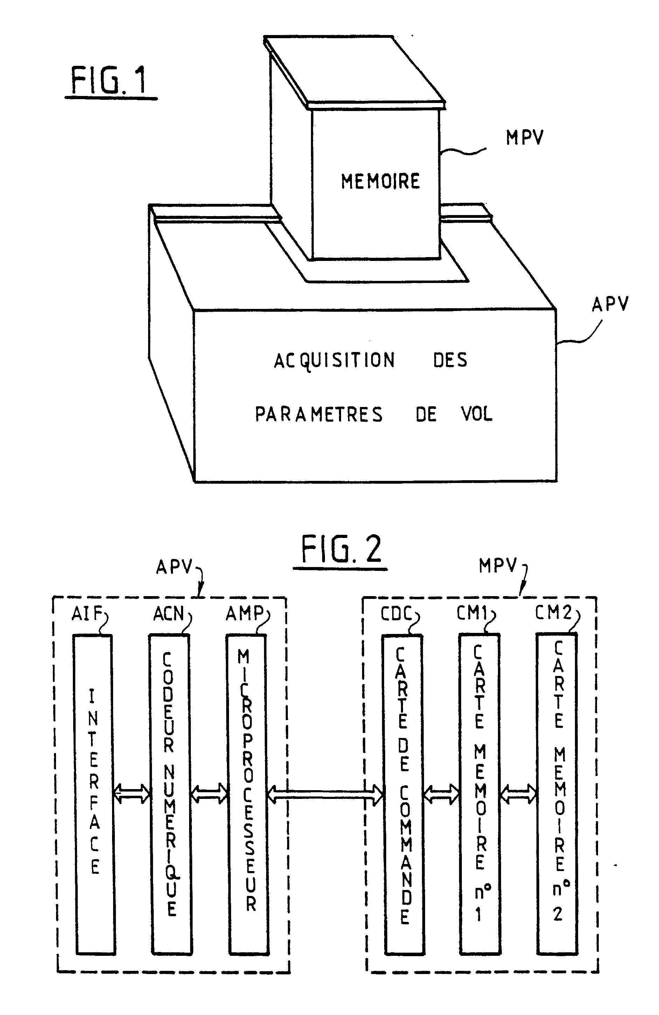

Sur la figure 1, la mémoire proprement dite MPV du dispositif enregistreur de vol est associée à un dispositif APV pour l'acquisition des paramètres de vol.

En lui-même, le dispositif APV ne fait pas partie de la présente invention. Il peut s'agir d'un dispositif d'acquisition classique, tel que ceux vendus par la Société de Fabrication d'Instruments de Mesure, 13, avenue Ramolfo Garnier, 91300 Massy, France.

La figure 2 fait apparaître le schéma électrique de principe de ce dispositif d'acquisition, qu'il est utile de connaître sommairement pour mieux comprendre l'invention. Ce dispositif comprend par exemple des moyens d'interface AIF avec les différents capteurs que comporte un aéronef, suivi (si nécessaire) d'un codeur analogique/numérique noté ACN, puis d'un microprocesseur ou plus généralement d'un processeur AMP, qui va être chargé de définir le jeu de paramètres de vol que le dispositif de mémoire selon l'invention a la charge d'enregistrer.

Toujours sur la figure 2, ce dispositif de mémoire MPV comprend, électriquement, une carte de commande CDC, une première carte mémoire CM1, et une seconde carte mémoire CM2.

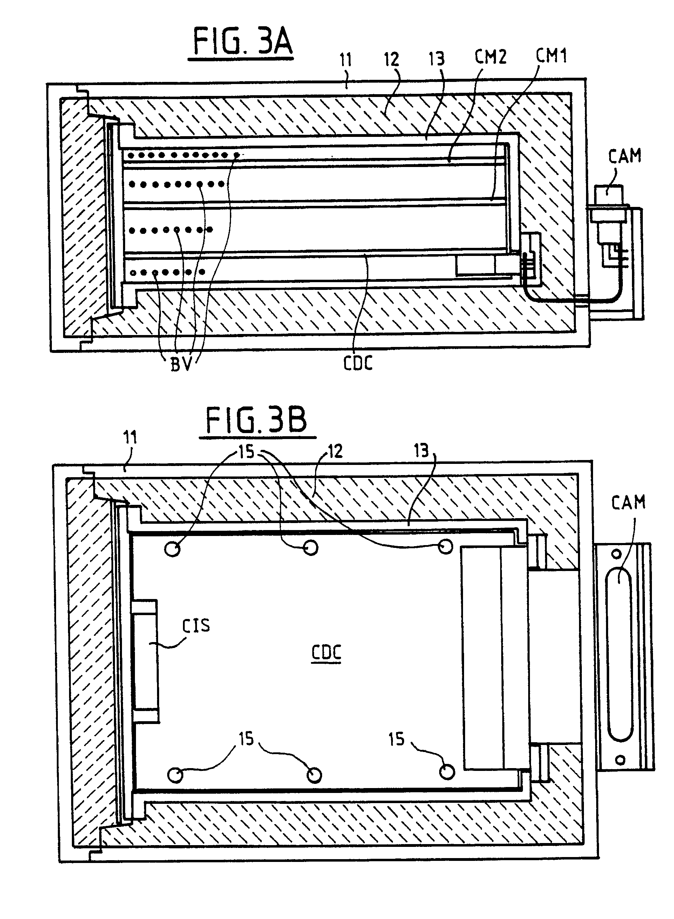

Les figures 3A et 3B font apparaître que le dispositif est logé dans une enveloppe externe 11, qui est l'enveloppe visible sur la figure 1.

C'est cette enveloppe qui a la charge de fournir les protections mécaniques générales externes, et notamment la résistance à l'écrasement et au poinçonnement, mentionnée plus haut. Cela est possible avec une enveloppe en acier d'épaisseur 4 millimètres.

Une seconde enveloppe 13 est prévue à l'intérieur de la première, tandis qu'un matériau anti-feu 12 est interposé entre les deux enveloppes. Ce matériau anti-feu est par exemple le matériau dit Aerocoat, disponible auprès de la Société Aérospatiale (France). Ce matériau, à base d'eau chimiquement liée, s'intercale sur 13 mm d'épaisseur entre les deux enceintes 11 et 13. Il se vaporise sous l'effet de la température en absorbant le maximum de calories. L'évaporation s'effectue par des pores incorporés à l'enceinte externe 11, et qui s'ouvrent à haute température.

A l'intérieur de l'enceinte interne 13 sont montées les trois cartes du dispositif de mémoire protégé selon l'invention.

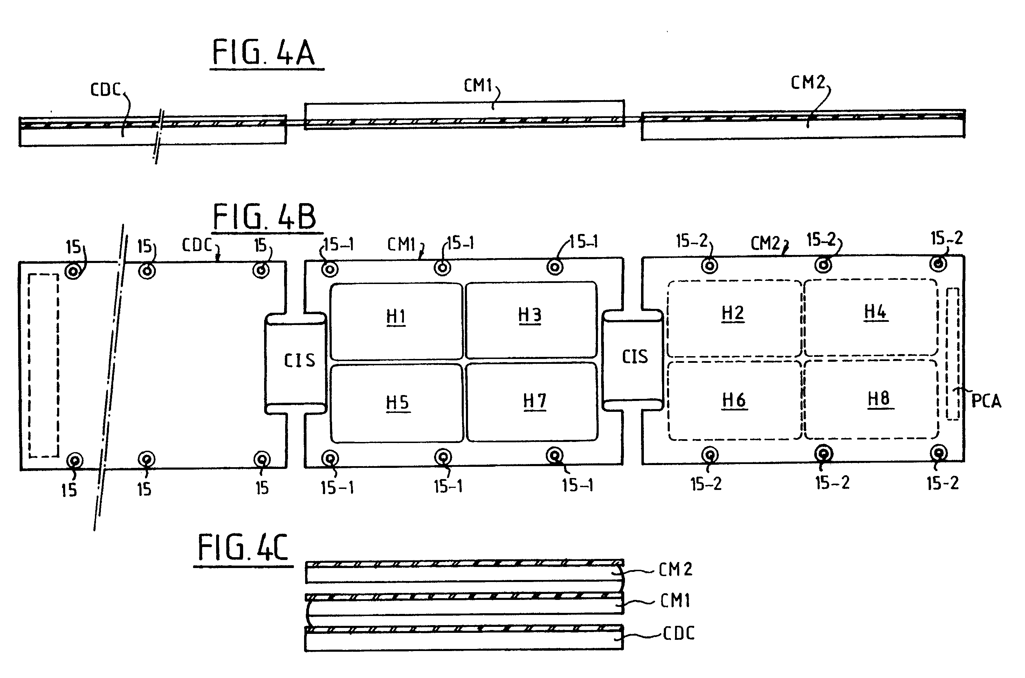

Comme visible sur les figures 4A à 4C, il s'agit d'une carte de commande CDC, d'une première carte mémoire CM1, et d'une seconde carte mémoire CM2, toutes de même format. Ces cartes sont interconnectées par un circuit imprimé souple CIS. La carte mémoire CM1, placée entre les deux autres, possède ses composants sur la face opposée à celle prévue pour les deux cartes voisines.

La figure 4C montre comment ces cartes peuvent être empilées pour occuper un volume parallélépipédique. Les cartes sont alors entretoisées, au niveau d'orifices 15 pour la carte de commande CDC, 15-1 pour la carte de mémoire CM1, et 15-2 pour la carte de mémoire cm2.

Les figures 4 montrent encore que la carte mémoire CM1 comporte quatre hybrides H1, H3, H5, H7, tandis que la carte CM2 comporte quatre hybrides H2, H4, H6, H8. Cette dernière est également munie, à l'extrémité, d'un pastillage PCA, au niveau du circuit imprimé souple CIS, pour permettre la fixation d'un connecteur auxiliaire. Comme on le verra plus loin, ce connecteur auxiliaire permet l'accès aux cartes de mémoire lorsque la carte de commande est devenue inutilisable, dans certaines conditions.

A partir de la figure 4C, on revient maintenant aux figures 3. L'espace occupé par ces cartes repliées à l'intérieur de l'enceinte 13 emplit, par son enveloppe géométrique, le volume de celle-ci. Les passages restant libres sont totalement obturés par des billes de verre BV (figure 3A). Avantageusement, la taille de ces billes de verre est comprise entre 45 et 90 micromètres.

On mentionnera encore que l'épaisseur de la paroi interne 13 est de 3 millimètres d'acier inoxydable. Le connecteur de la carte de commande CDC communique avec le connecteur externe CAM par l'intermédiaire d'une fenêtre en biseau pour le passage des fils de liaison. Cette fenêtre en biseau est elle-même protégée par une seconde paroi d'acier. Cette fenêtre est fermée et comprend également le matériau anti-feu dit Aerocoat.

Les essais ont montré qu'une telle disposition permet de satisfaire les conditions précitées quant à l'effort d'écrasement, l'effort de poinçonnement, et la résistance au feu.

Il en est de même pour la résistance aux chocs, compte tenu du fait que les modules de circuits hybrides que l'on examinera maintenant résistent à 3000 fois l'accélération de la pesanteur.

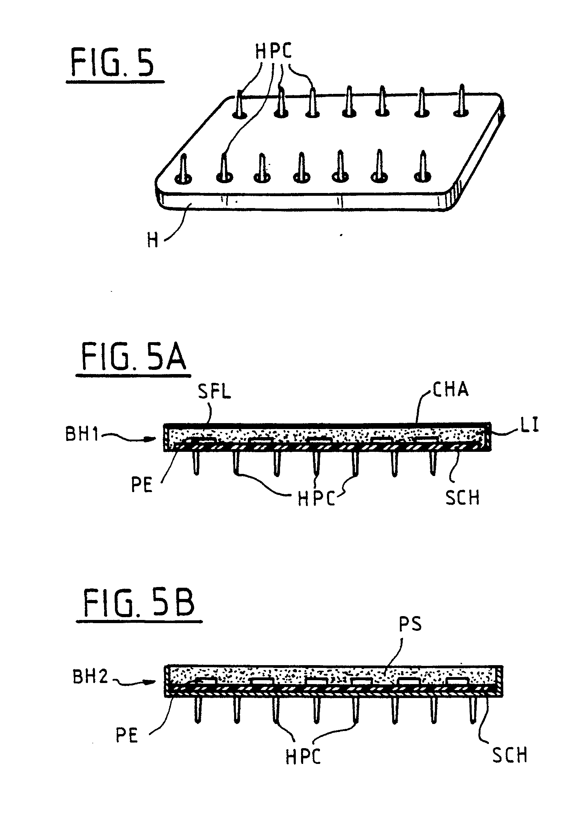

Ces modules hybrides sont illustrés schématiquement en perspective sur la figure 5, à l'envers, c'est-à-dire avec leurs pattes de connexion HPC vers le dessus.

La figure 5A illustre un premier mode de réalisation de ces modules hybrides, mode de réalisation noté BH1. Le boîtier métallique du module hybride est ici fermé par un couvercle supérieur CHA, muni d'un orifice à l'emplacement SFL. On distingue intérieurement le substrat de céramique SCH du circuit hybride, sur lequel apparaissent les puces électroniques PE. Sur ce substrat sont également montées les pattes HPC, qui traversent la paroi métallique du boîtier à travers des perles de verre, de manière connue. Après montage, un liquide inerte LI, non polluant à l'égard des puces électroniques, tel que le liquide FLUORINERT, référence FC43, vendu par la Société 3M, est introduit à travers l'orifice du couvercle CHA. Cet orifice est ensuite fermé par une soudure SFL.

Il s'est avéré que ce dispositif a résisté à des pressions avoisinant 1000 bars

Un second mode de réalisation des circuits hybrides est illustré sur la figure 5B. On y retrouve le substrat de céramique SCH muni des puces PE, avec les pattes de connexion HPC. Le boîtier BH2 est cette fois ouvert vers sa partie supérieure. Une résine dure et non polluante pour les puces électroniques est répartie (une ou quelques gouttes suffisent) sur les puces ainsi que sur les pattes. Cette résine peut être celle vendue par HYSOL sous la référence ES4228 (dureté 89 SHORE D). Le reste du boîtier est rempli d'une composition silicone PS solide, de dureté moyenne et de faible coefficient de dilatation. Cette composition est par exemple le produit RTV 31-40 de DOW CORNING (dureté 25 SHORE A, coefficient de dilatation 300 $10^{-6}$). Ce second mode de réalisation du boîtier s'est avéré propre à tenir une pression d'environ 850 bars.

Ainsi équipé, le dispositif de mémoire selon l'invention satisfait les contraintes d'accélération et de pression mentionnées plus haut. Reste la tenue à la corrosion, et en particulier la tenue à la corrosion marine, qui est en principe la plus délicate.

A cet effet, un produit silicone tel que le RTV 31-40 précité est ajouté. Ce produit silicone peut être ajouté partout, lorsque les circuits hybrides sont fondés sur le second mode de réalisation (figure 5B). Dans le cas où le circuit hybride est celui du premier mode de réalisation (figure 5A), on pourra distribuer une épaisseur d'un à deux millimètres de ce produit silicone sur les cartes de circuit imprimé, ainsi que sur les pattes de connexion, des circuits hybrides notamment, sur ces cartes.

Contrairement à ce qui était le cas avec les dispositifs à bande magnétique de la technique antérieure, la présente invention permet également de se préoccuper de la sécurité des données en ce qui concerne l'électronique proprement dite.

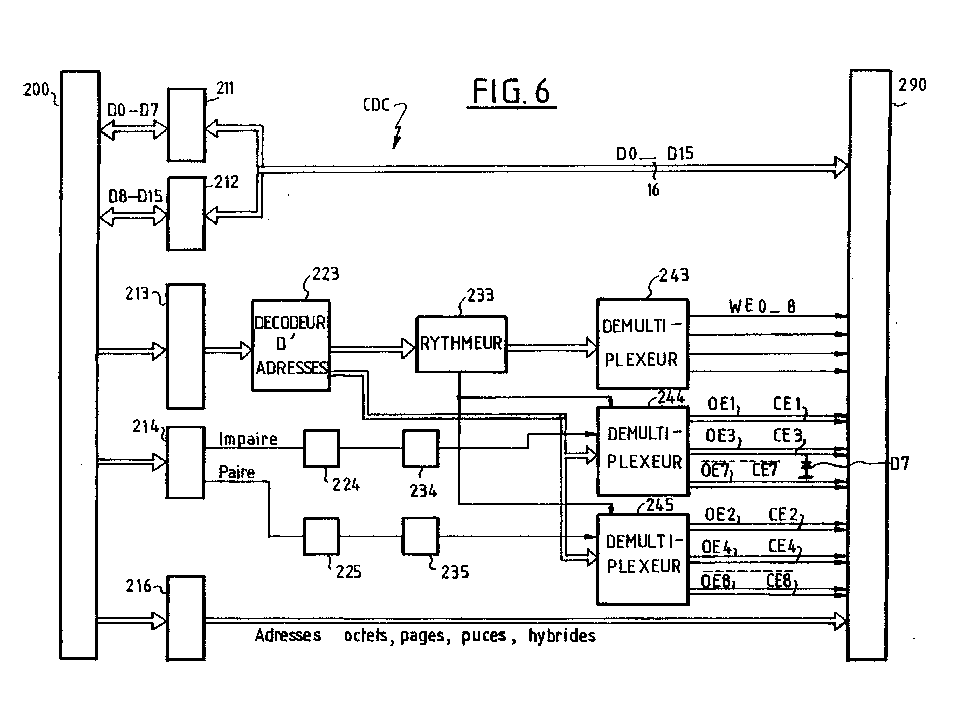

Un premier aspect matériel de la protection électronique des données fait intervenir le rôle de fusible de la carte de commande. Celle-ci apparaît, en schéma de principe simplifié, sur la figure 6.

En 200 est représenté le connecteur de liaison avec le microprocesseur AMP de la figure 2 (ce connecteur 200 correspond au regroupement des connecteurs CAM et de la connexion sur la carte CDC, si l'on retourne aux figures 3A et 3B).

Comme illustré schématiquement sur la figure 6, tous les signaux d'entrée sont ramenés à la masse par des diodes Zener rapides DZ, unidirectionnelles, permettant d'écrêter tous les transitoires inférieurs à -1 voit ou supérieur à +7 Volts.

Du connecteur 200 partent des liaisons en bus de données $D_0$ à $D_7$ ainsi que $D_8$ à $D_{15}$, qui vont respectivement vers deux circuits émetteurs/récepteurs de ligne 211 et 212. Les sorties de ceux-ci définissent le bus de données com-plet, à 16 fils, $D_0$ à $D_{15}$, qui est repris vers un connecteur 290 pour aller vers les cartes mémoires par le circuit imprimé souple CIS (figure 3).

Le connecteur d'entrée 200 reçoit également des informations d'adresses. Une partie de celles-ci est appliquée à un circuit de ligne d'adresse 213, suivi d'un décodeur d'adresse 223. Celui-ci alimente tout d'abord un rythmeur 233, suivi d'un démultiplexeur 243. Le démultiplexeur fournit des signaux d'autorisation d'écriture (write enable), notés WE 0 à 8, et qui transitent sur quatre fils.

Le rythmeur fournit également des signaux de commande à deux autres démultiplexeurs 244 et 245, chargés respectivement de fournir d'autres signaux de commande pour l'écriture aux circuits hybrides H1, H3, H5, H7 d'une part, H2, H4, H6, H8 d'autre part. Ces signaux comprennent des signaux OE d'autorisation de sortie (Output Enable) et des signaux CE de validation de puces (Chip Enable).

Le décodeur d'adresse 223 fournit également les signaux d'adresses à décoder aux démultiplexeurs 244 et 245.

D'autres signaux d'adresses émanant du connecteur d'entrée 200 vont vers un circuit de ligne 214, qui les distribue en adresses impaires et paires. Les premières concernent le démultiplexeur 244 et les secondes le démultiplexeur 245. Ces signaux de commande en fonction de la parité sont appliqués à travers deux niveaux d'étages intermédiaires 224 et 234 d'une part, 225 et 235 d'autre part, de façon qu'on ait le même nombre de couches de circuits logiques entre toutes les entrées et toutes les sorties de la carte de mémoire.

Enfin, le reste des signaux d'adresses est repris par un circuit de ligne 216, qui élabore des signaux d'adresses d'octets, de pages dans une puce, de puces et de circuits hybrides, à destination du connecteur de sortie 290.

L'homme de l'art comprendra, de ce qui précède, qu'il existe une distribution séparée des signaux de commande des deux mémoires, ou plus, lorsqu'il s'agit d'écrire dans celles-ci. Par ailleurs, l'écriture est pratiquement "paralysée" si les bons signaux ne se présentent pas tous, et ce dans le bon ordre.

Par l'usage de quatre couches de circuits à l'intérieur de la carte de commande CDC, on assure que celle-ci peut aussi jouer un rôle de fusible si des tensions trop élevées venaient à être présentées sur le connecteur d'entrée 200. Ce rôle de fusible est, au plan de la sécurité, complété par celui des diodes Zener DZ.

Un autre élément de sécurité, sur lequel on reviendra ci-après, réside en ce que les données sont systématiquement réparties, suivant l'ordre dans lequel elles se présentent, en des données paires et des données impaires, qui seront appliquées de manière alternée aux cartes de mémoire elles-mêmes ainsi qu'aux circuits hybrides eux-mêmes, qui en constituent le composant matériel élémentaire, dans le mode de réalisation décrit.

Il convient ici de revenir brièvement sur le connecteur auxiliiaire PCA de la figure 4B. Lorsque la carte de commande CDC a joué son rôle de fusible, pour quelque raison que ce soit, l'accès aux informations présentes dans la mémoire de-meure disponible par l'implantation d'un connecteur auxiliaire sur le pastillage PCA.

On peut encore mentionner la protection des données enregistrées à l'égard des perturbations électromagnétiques. Celles-ci résultent de trois enceintes métalliques ici présentées, à savoir celles des circuits hybrides, et les deux enceintes 13 et 11. Il s'y ajoute une quatrième enceinte externe a l'intérieur de laquelle est logé l'ensemble des deux éléments de la figure 1.

Il convient encore d'ajouter que l'effacement complet de la mémoire est pratiquement impossible, car il nécessiterait :
- la présence d'un potentiel supérieur à +15 Volts sur chacun des huit fils OE reliés repectivement aux huit hybrides. Or, il n'y a pas de tension autre que l'alimentation de +5 Volts à l'intérieur du boîtier de mémoire protégé, et les diodes Zener déjà mentionnées neutralisent tout potentiel supérieur à +7 Volts à l'entrée du boîtier;

- il faudrait aussi la présence de niveaux bas sur les connexions WE ainsi que CE. Les signaux WE cheminent par quatre liaisons distinctes. Les signaux CE cheminent par huit fils liés chacun à l'un des hybrides. Du fait que ces fils sont liés aux cinq commandes du boîtier protégé, et que ces commandes doivent se présenter selon un chronogramme très précis et répétitif par hybride, il n'est pratiquement pas possible d'obtenir une écriture indésirée. De plus, en cas de coupure, certains des fils sont rappelés à un potentiel de +5 Volts ou à la masse, de manière à activer la position lecture.

Par ailleurs, en utilisant préférentiellement des puces des circuits intégrés de 64 kbits EEPROM telles que vendues par la Société SEEQ, on obtient l'avantage de ces puces que toutes les possibilités d'écriture sont inhibées si la tension +5 Volts d'alimentation vient à descendre au-dessous de +3 Volts, par exemple du fait d'une coupure ou d'une mise à la masse de l'alimentation à +5 Volts.

Un effacement partiel de la mémoire a également très peu de risque de se produire, car il faudrait que les conditions suivantes soient remplies :
- adressage positionné dans une zone de mémoire déjà écrite,
- signal de validation d'écriture présent,
- séquencement entre les signaux d'écriture, d'échantillonnage d'adresses et d'échantillonnage de données conforme à un cycle d'écriture.

De plus, dans l'hypothèse où toutes ces circonstances défavorables seraient rencontrées, une seule page d'une seule puce pourrait être effacée.

On verra maintenant que l'invention présente d'autres aspects qui permettent de limiter les inconvénients qui peuvent en résulter.

Mais auparavant, il est souhaitable d'examiner un autre aspect de l'invention, qui concerne une compression de données permettant une bien meilleure utilisation des capacités des mémoires électroniques statiques.

On prendra comme base le fait que le nombre de paramètres de vol à enregistrer est de 64, remarque étant faite que l'enregistrement de certains paramètres peut être redondant.

Pour l'enregistrement en mémoire, le vol est donc décomposé en cycles de 64 paramètres, codés en principe chacun sur 12 bits.

On aura tout d'abord, a priori, un rangement de cycles, en fonction de l'ordre dans lequel il se présente, un cycle I, donc impair, qui ira vers les hybrides impairs de la carte de mémoire N 1 (impaire), et le cycle suivant sera un cycle P ou pair, qui ira vers les hybrides pairs de la carte mémoire N 2 (paire).

En d'autres termes, si l'on considère deux cycles de vol consécutifs comprenant respectivement deux échantillons consécutifs d'un même paramètre de vol (échantillonné une fois par cycle), l'un de ces échantillons ira dans l'une des cartes mémoire, et l'autre dans l'autre carte mémoire.

Maintenant, la compression de données selon l'invention fait intervenir la définition de cycles de référence (CR-I et CR-P), suivis chacun de 179 cycles secondaires (CS-I ou CS-P). L'ensemble constitué par un cycle de référence et 179 cycles secondaires couvre, au point de vue de l'enregistrement des paramètres de vol, un "module de vol" dont la durée couvre par exemple une minute du vol.

Bien entendu, un module de vol comprendra 180 cycles impairs dont un cycle de référence, et 180 cycles pairs dont un cycle de référence, en mode normal.

On ne considère plus maintenant que l'un de ces modules de vol en sa partie impaire, la partie paire étant identique.

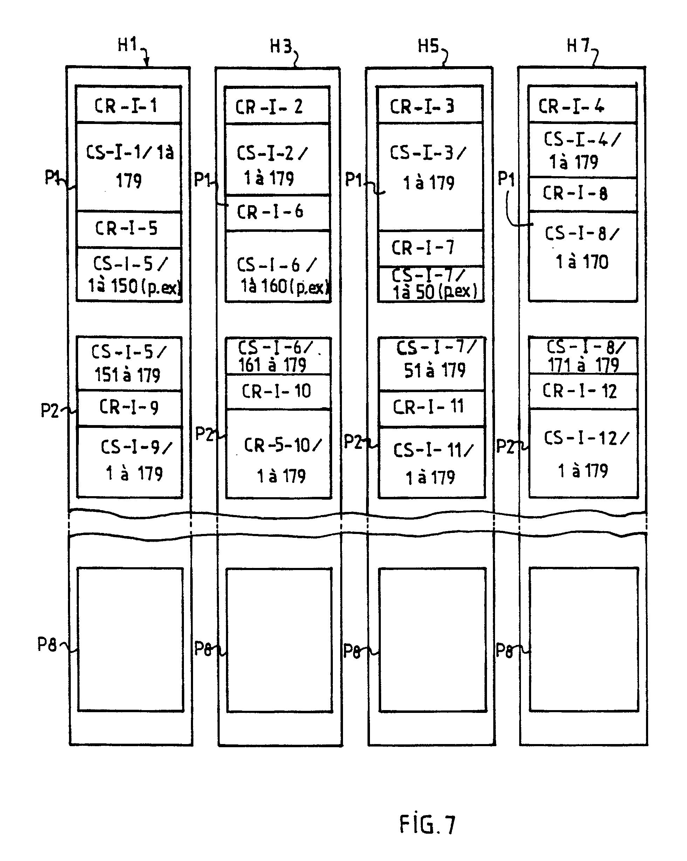

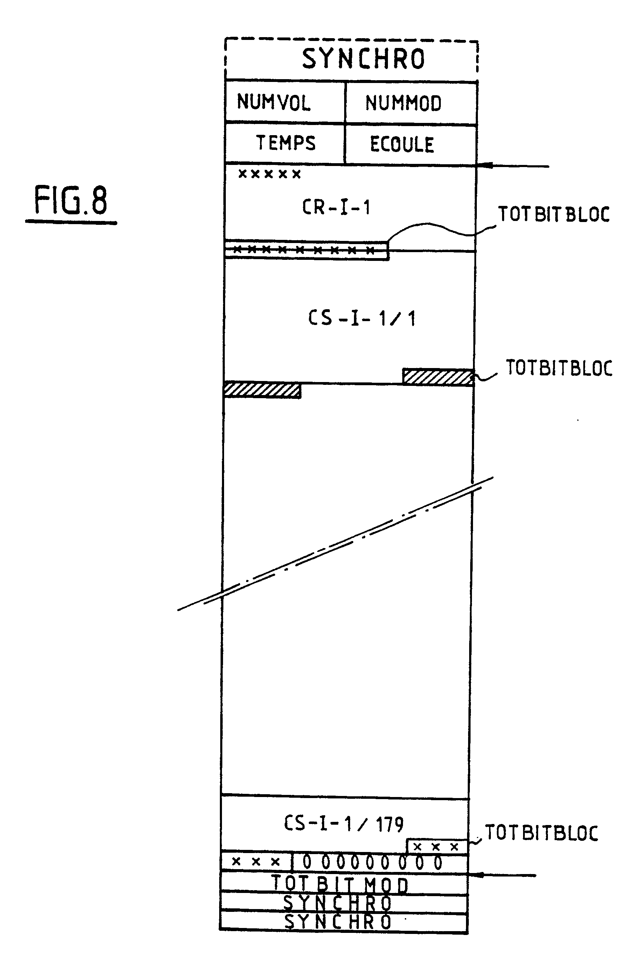

Un tel module de vol va, comme illustré sur les figures 7 et 8, commencer par un cycle de référence CR-I-1 qui comprend l'enregistrement complet de tous les paramètres intéressés.

L'enregistrement de ce cycle de référence R-I-1 va occuper un certain nombre de bits en mémoire. Comme indiqué en figure 8, ce nombre de bits constitue une information TOTBITBLOC enregistrée immédiatement après le bloc de données relatif au cycle de référence CR-I-1.

Les 179 cycles secondaires suivants CSI-1 à 179 ne feront pas l'objet d'un enregistrement intégral du codage binaire de tous les paramètres de vol. Au contraire, le codage des données est le suivant :
- si, dans les limites de précision déterminées, le paramètre de vol concerné n'a pas varié depuis sa valeur précédente (du même "cycle"), on enregistre seulement deux bits identificateurs, par exemple 00, indiquant cet état de fait; ou mieux un seul bit 0, ce qui améliore la compression de données;
- si, par rapport à sa valeur précédente, le paramètre de vol concerné n'a varié que dans un domaine restreint choisi, on enregistre un identificateur par exemple 10 représentant cet état de fait plus un nombre de bits suffisant pour représenter la variation du paramètre de vol, compte tenu du domaine restreint de variation choisi;
- si, toujours par rapport à sa valeur précédente, le paramètre de vol a varié en dehors dudit domaine restreint, alors on enregistre l'identificateur 11 (par exemple) suivi de la totalité des bits formant le codage du paramètre de vol sujet à variations importantes.

Il a été observé que cette technique de compression s'applique parfaitement à la dynamique d'évolution de chaque paramètre, tout en permettant la restitution stricte et intégrale de celui-ci.

Les essais ont révélé que cette technique de compression des données permet de diminuer d'un facteur 6 environ le volume de bits nécessaires, par rapport à l'enregistrement complet de la technique antérieure, et ce, sans perte d'information.

Comme pour le cycle de référence, chaque cycle secondaire CS ainsi compressé est suivi de l'indication du total TOTBITBLOC du nombre de bits qu'il comporte, compte tenu de la compression.

Cela se poursuit jusqu'au dernier cycle secondaire CS-I-1/179. L'information TOTBITBLOC de celui-ci est suivi de bits de remplissage, pour terminer la dernière ligne utilisée dans la mémoire, comme visible sur la figure 8.

Après cela, on prévoit une indication TOTBITMOD (total des bits ou octets d'un module), qui couvre un segment ou ligne complet de la mémoire, suivi de deux indications "synchro", construites également en format fixe, comme le TOTBITMOD.

On revient maintenant au haut de la figure 8. Avant le cycle de référence CR-I-1, mais après l'information de synchronisation du module de vol précédent, on aura placé deux indications couvrant une ligne, et qui sont respectivement le numéro du vol NUMVOL et le numéro du module de vol NUMMOD. A la ligne suivante, on inscrit le temps écoulé depuis le début du vol, ces informations constituent le bloc identité du module de vol.

Il est utile d'examiner maintenant la figure 7, qui fait apparaître le rangement en mémoire dans la carte mémoire CM1 de tous les blocs formant les "cycles" impairs.

A titre d'exemple, le premier cycle de référence CR-I-1 est inscrit dans la puce P1 de l'hybride H1. Il est suivi des n = 179 cycles secondaires associés distingués par la marque CS-I-1/1 à 179.

Le cycle de référence CR-I-2 est inscrit dans la puce P1 de l'hybride H3, suivi des n cycles secondaires CS-I-2/1 à 179. Il en est de même pour le cycle CR-I-3 dans la puce P1 de l'hybride H5 avec ses cycles secondaires et le cycle CR-I-4 dans la puce P1 de l'hybride H7, avec ses cycles secondaires.

Après cela, le cycle de référence CR-I-5 revient dans la puce P1 de l'hybride H1, où la suite de ces cycles secondaires peut s'étaler sur la puce P2 du même hybride, le remplissage se poursuivant, ainsi, en séquence.

Le même processus se produit dans l'autre carte de mémoire, avec les cycles CR-P-1 (de référence), suivi de CS-P-1/1 à 179, et ainsi de suite.

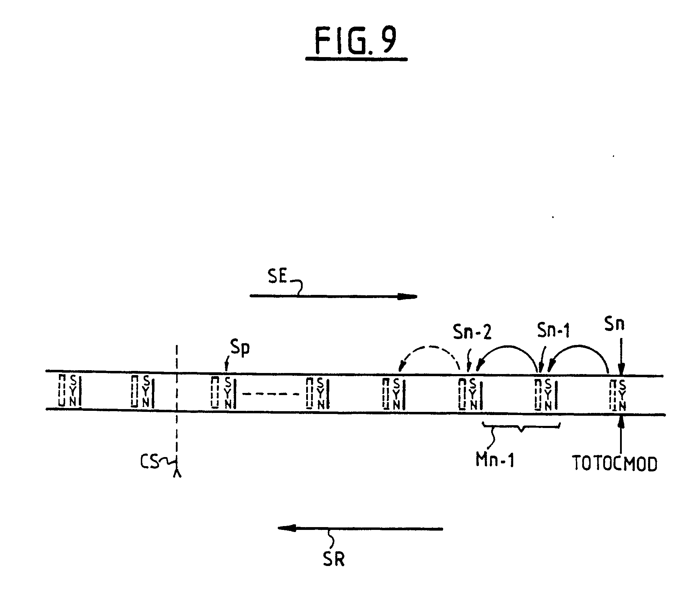

La figure 9 fait maintenant apparaître la présentation des modules de vol successifs, dans la mémoire, par hybride.

La fin d'enregistrement se produit sur un signal de synchronisation (en pratique un bloc de deux signaux de synchronisation).

L'enregistrement des données dans l'hybride H considéré s'est effectué dans le sens SE. Il est possible de mettre en oeuvre la mémoire selon l'invention sans y incorporer de catalogue ("Directory"), comme on le verra maintenant.

Pour cela, il est avantageux de faire les recherches (ou recalages) dans la mémoire dans le sens SR, inverse de SE.

Une fois qu'on a repéré le dernier signal de synchronisation Sn, il suffit de lire immédiatement au-dessus le nombre total de bits (ou d'octets TOTOCMOD) du module terminé par ce bloc de synchronisation pour remonter au début de ce module, et ainsi de suite avec les signaux de synchronisation Sn-1, Sn-2.

Différentes conditions spéciales peuvent se produire, tenant compte par exemple du fait que le dernier module est complet mais sans singal de synchronisation, ou bien qu'il est incomplet, ou bien qu'il y a eu une coupure du réseau d'alimentation de l'aéronef en cours d'écriture d'un module dans un circuit hybride (coupure CS, à gauche de Sp, avec un TOTOCMOD erroné, détectable par exemple par erreur de parité), ou bien que le recalage sur la synchronisation s'effectue à cheval entre le début et la fin d'un circuit hybride, et ce avec ou sans coupure réseau de l'aéronef, ou bien que le total des bits d'un module se trouve à cheval entre les adresses de début et de fin d'un hybride (ce total étant constitué d'un octet à la fin de l'hybride, et d'un autre octet en début de l'hybride), ou bien encore que la mémoire est totalement vierge.

L'expérience a montré qu'un recalage est toujours possible par les moyens de l'invention, dans toutes les conditions exposées ci-dessus. On détermine des "modules de vol certifiés". Sur la figure 9, on suppose que le TOTOCMOD adjacent à Sn est incorrect ou incomplet. Le premier module certifié est donc Mn-1.

Après cela, on peut procéder à un rangement des modules de vol certifiés. Il s'agit de déterminer le vol le plus ancien et le vol le plus récent, et de connaître l'adresse en mémoire de leur premier module et/ou de leur dernier module.

On peut enfin procéder à une initialisation de table indiquant les adresses de départ sur un circuit hybride pour un nouvel enregistrement.

Lorsqu'il s'agit non pas de préparer la mémoire pour un nouvel enregistrement, mais de rechercher des enregistrements antérieurs, il est souhaitable d'aller plus loin.

On détermine tout d'abord quel est le plus vieux vol dont des modules sont présents dans les huit circuits hybrides.

On détermine ensuite quel est le premier module à restituer dans ce plus vieux vol, ainsi que le numéro d'hybride où se trouve ce premier module.

On procède alors à une remise à jour d'une table contenant les numéros d'identité des blocs identité des premiers modules à restituer.

On peut alors constituer une table formant sommaire de différents vols et modules de vol.

Enfin, on peut accéder directement à tout module de vol de tout vol contenu dans la mémoire.

Ces opérations sont intéressantes en pratique. En effet, l'homme de l'art aura remarqué que la présente invention substitue à l'enregistrement purement séquentiel d'une bande magnétique un enregistrement qui demeure séquentiel, mais d'une manière répartie à l'intérieur de différents sous-ensembles matériels de mémoire.

Or, du fait qu'est également prévue une compression de données, il est tout à fait possible qu'un module de vol ait pris, du fait des variations importantes (accidentelles ou non) d'un ou plusieurs paramètres, une importance (en termes de taille de mémoire requise) qui dépasse largement celle dont ont eu besoin les modules de vol voisins. Il s'ensuit alors un risque d'effacement, dans l'hybride concerné, de modules de vol antérieurs, dont les "voisins" sont par contre demeurés présents dans les autres hybrides. C'est de cela que tiennent compte les différentes étapes qui viennent d'être exposées sur le recalage dans la mémoire selon l'invention.

Dans une variante de l'invention, on peut remplacer les circuits hybrides décrits plus haut par des circuits de technologie dits PLCC ("Plastic Leadless chip Carrier") tels que les circuits vendus par la société XICOR (Etats-Unis). Cette société vend par exemple des puces de 256 K bits sous la référence X28 256 PLCC boîtier J ou JI suivant la gamme de températures nominales que peuvent supporter normalement de tels circuits.

Dans l'exemple décrit plus haut, on a considéré deux ensembles de mémoire comprenant chacun quatre circuits hybrides en boîtier. La variante consiste à remplacer chaque boîtier de circuit hybride par une pluralité de puces de type PLCC, par exemple du modèle indiqué ci-dessus.

La demanderesse a observé que ces puces PLCC sont intrinsèquement étanches à l'air. En utilisant de telles puces, il n'est donc plus nécessaire de recourir au remplissage par un produit inerte, comme cela était le cas pour les boîtiers de circuits hybrides.

Par ailleurs, la structure matérielle de l'enregistreur de vol peut également changer. Notamment, le recours à des circuits PLCC peut faire qu'au lieu de deux cartes comportant chacune l'un des deux ensembles de mémoire, on doive matérialiser chaque ensemble de mémoire par plusieurs cartes pour lui seul, c'est-à-dire deux jeux de cartes consacrés chacun à l'un des ensembles de mémoire.

## Revendications

1 - Dispositif enregistreur de vol, du type comportant une enceinte de protection (MPV) traversée par des connexions électriques d'alimentation et de signaux aboutissant à des organes de mémoire logés à l'intérieur de l'enceinte, et comprenant des circuits (H1-H8) de mémoire non volatile à réinscription électrique, susceptibles d'accès par l'intermédiaire desdites connexions;
caractérisé en ce que des mesures consécutives d'une même grandeur à enregistrer sont distribuées alternativement à au moins deux ensembles (CM1, CM2) de circuits de mémoire, et en ce que des groupes consécutifs de données à enregistrer dans chaque ensemble sont distribués séquentiellement aux différents circuits de celui-ci (H1 à H7; H2 à H8).

2 - Dispositif enregistreur de vol, du type comportant une enceinte de protection (MPV) traversée par des connexions électriques d'alimentation et de signaux aboutissant à des organes de mémoire logés à l'intérieur de l'enceinte, et comprenant des circuits (H1-H8) de mémoire non volatile à réinscription électrique, susceptibles d'accès par l'intermédiaire desdites connexions caractérisé par le fait que tout vol fait l'objet d'un enregistrement alterné de ses paramètres dans deux zones différentes de mémoire, ce qui permet de disposer, en cas de panne totale ou partielle d'une des deux zones, de toute la durée du vol à cadence moitié.

3 - Dispositif selon l'une des revendications 1 et 2, caractérisé en ce que les ensembles de mémoire sont électriquement actionnés par des voies séparées.

4 - Dispositif selon l'une des revendications 1 à 3, caractérisé en ce que chaque groupe de données ou "module de vol" contient normalement un nombre entier de cycles (CR, CS1 à CS179) comprenant chacun l'ensemble des paramètres de vol à enregistrer.

5 - Dispositif selon la revendication 4, caractérisé en ce que chaque module de vol contient un cycle de référence (CR) comprenant un bloc de données enregistrées qui forme un codage complet de l'ensemble des paramètres de vol à enregistrer, suivi de cycles secondaires (CS1, CS179), comprenant des blocs de données constitués chacun d'un identificateur, capable de prendre au moins trois état différents, tandis que le reste du bloc est : inexistant, si l'identificateur indique que le paramètre de vol n'a pas varié par rapport à sa valeur précédente, à une précision choisie ; constitué d'un nombre restreint de bits si l'identificateur indique que le paramètre de vol n'a varié que dans un domaine restreint choisi, par rapport à sa valeur précédente ; constitué de la totalité des bits du codage dans l'autre cas.

6 - Dispositif selon la revendication 5, caractérisé en ce qu'à chaque module de vol est associé l'enregistrement initial d'une identification du vol (NUMVOL), d'une identification du module de vol (NUMMOD), et du temps écoulé depuis le début du vol.

7 - Dispositif selon l'une des revendications 5 et 6, caractérisé en ce que chaque bloc de données relatif à un cycle de vol est suivi de l'indication du nombre de bits que contient ce bloc (TOTBITBLOC), et en ce que chaque groupe de données définissant un module de vol est suivi de l'indication du nombre de bits que contient le groupe (TOTBITMOT), puis d'au moins un signal spécial de synchronisation (SYNCHRO).

8 - Dispositif selon la revendication 7, caractérisé en ce que le recalage dans la mémoire après une interruption d'alimentation s'effectue en parcourant la mémoire à l'envers pour y chercher d'abord les signaux de synchronisation relatifs au module le plus récent du vol le plus récent, puis pour suivre les modules de vol en remontant le temps.

9 - Dispositif selon la revendication 8, caractérisé en ce que le recalage est suivi de la détermination du vol le plus ancien, dont tous les modules de vol sont représentés en mémoire.

## FIG.1

MPV

MEMOIRE

APV

ACQUISITION DES PARAMETRES DE VOL

## FIG.2

APV

AIF — INTERFACE

ACN — CODEUR NUMERIQUE

AMP — MICROPROCESSEUR

MPV

CDC — CARTE DE COMMANDE

CM1 — CARTE MEMOIRE n° 1

CM2 — CARTE MEMOIRE n° 2

## FIG. 3A

## FIG. 3B

FIG. 4A

CM2

CM1

CDC

FIG. 4B

PCA

15-2    15-2    15-2    15-2

H4    H8

CM2

H2    H6

CIS

15-1    15-1

H3    H7

CM1    15-1

H1    H5

15-1    15-1

CIS

15    15

CDC

15    15

15    15

FIG. 4C

CM2

CM1

CDC

FIG. 5

HPC

H

FIG. 5A

SFL          CHA

BH1 →                                    LI

PE

HPC          SCH

FIG. 5B

PS

BH2 →

PE

HPC          SCH

FIG.6

H1     H3     H5     H7

| CR-I-1 | CR-I-2 | CR-I-3 | CR-I-4 |

P1

CS-I-1/ 1à 179

CS-I-2 / 1 à 179

CS-I-3/ 1 à 179

CS-I-4/ 1à 179

CR-I-5

CR-I-6

CR-I-8

CR-I-7

CS-I-5 / 1à 150 (p.ex)

CS-I-6 / 1à 160 (p.ex)

CS-I-7/ 1à 50 (p.ex)

CS-I-8/ 1 à 170

CS-I-5/ 151 à 179

CS-I-6/ 161 à 179

CS-I-7/ 51 à 179

CS-I-8/ 171 à 179

P2

CR-I-9

CR-I-10

CR-I-11

CR-I-12

CS-I-9/ 1 à 179

CR-5-10/ 1 à 179

CS-I-11/ 1 à 179

CS-I-12/ 1 à 179

P8

FIG.7

## FIG.8

| SYNCHRO | |
|---|---|
| NUMVOL | NUMMOD |
| TEMPS | ECOULE |

x x x x x

CR-I-1 — TOTBITBLOC

x x x x x x x x x x

CS-I-1/1

TOTBITBLOC

CS-I-1/179 — TOTBITBLOC

x x x | 0 0 0 0 0 0 0 0 0

TOT BIT MOD

SYNCHRO

SYNCHRO

# FIG. 9

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4 ) |
|---|---|---|---|
| A | WO-A-8503583 (SUNDSTRAND DATA CONTROL)<br>* le document en entier *<br>--- | 1, 2 | G07C5/08<br>H05K5/02 |
| A | WO-A-8503586 (SUNDSTRAND DATA CONTROL)<br>* le document en entier *<br>--- | 1, 2 | |
| A | WO-A-8602750 (SUNDSTRAND DATA CONTROL)<br>* le document en entier *<br>--- | 1, 2 | |
| A | FR-A-2551619 (SUNDSTRAND DATA CONTROL)<br>* le document en entier *<br>----- | 1 | |

DOMAINES TECHNIQUES
RECHERCHES (Int. Cl.4 )

G07C
H05K
G06F

Le présent rapport a été établi pour toutes les revendications

| Lieu de la recherche | Date d'achèvement de la recherche | Examinateur |
|---|---|---|
| LA HAYE | 21 FEVRIER 1991 | TOUSSAINT F.M.A. |